# EUROPÄISCHE PATENTSCHRIFT

(11) **EP 2 919 343 B1**
(45) Veröffentlichungstag und Bekanntmachung des Hinweises auf die Patenterteilung: **14.09.2016**
(21) Anmeldenummer: 14159153.7
(22) Anmeldetag: 12.03.2014
(51) Int. Cl.: H02G 3/12, H02G 3/18, A47B 21/06, A47B 97/00

(54) **Einbau-Gehäuse zur Aufnahme und Befestigung einer elektrischen Komponente und Gegenstand mit einem derartigen Einbau-Gehäuse sowie Verfahren zur Befestigung eines derartigen Einbau-Gehäuses an einem Gegenstand**
Installation housing for holding and fixing an electrical component and object having such an installation housing and method for attaching such an installation housing to an object
Boîtier d'encastrement pour loger et fixation d'un composant électrique, objet doté d'un tel boîtier d'encastrement et procédé de fixation d'un tel boîtier d'encastrement à un objet

(43) Veröffentlichungstag der Anmeldung: 16.09.2015
(73) Patentinhaber: Würth Elektronik eiSos GmbH & Co. KG, 74638 Waldenburg (DE)
(72) Erfinder: Hantschel, Jörg, 81245 München (DE); Frank, Robert, 86836 Untermeitingen (DE)
(74) Vertreter: Rau, Schneck & Hübner Patentanwälte Rechtsanwälte PartGmbB

(56) Entgegenhaltungen:
- EP-A1- 1 916 751
- EP-A2- 2 164 143
- DE-B3-102008 014 382
- US-A1- 2008 054 135

## Beschreibung

Die Erfindung betrifft ein Einbau-Gehäuse zur Aufnahme und Befestigung einer elektrischen Komponente gemäß dem Oberbegriff des Anspruchs 1. Die Erfindung betrifft ferner einen Gegenstand, insbesondere ein Möbel mit einem derartigen Einbau-Gehäuse. Weiterhin betrifft die Erfindung ein Verfahren zur Befestigung eines derartigen Einbau-Gehäuses an einem Gegenstand.

Aus der DE 10 2008 014 382 B3 ist eine Einbaudose mit einem äußeren Ring bekannt, der in regelmäßigen Abständen in seiner Umfangsfläche unterbrochen ist. Im Bereich der Unterbrechungen sind Spreizfinger ausgebildet. Die Einbaudose weist weiterhin einen Spannring mit zu den Spreizfingern korrespondierenden Spreizschrägen auf. Durch Spannschrauben wird der äußere Ring mit dem Spannring verbunden, wodurch die Spreizfinger durch die Spreizschrägen aufgespreizt werden.

Aus der EP 2 164 143 A2 ist eine Fußbodendose bekannt, die umfangsseitig angeordnete, flexible Zungen aufweist. Die Zungen dienen als Widerlager, um die Fußbodendose in einer Öffnung des Fußbodens zu befestigen.

Aus der US 2008/0054135 A1 ist ein Einbau-Gehäuse zur Befestigung eines elektrischen Geräts in einer Fußboden-Ausnehmung bekannt. Das Einbau-Gehäuse umfasst einen Halter mit flexiblen Halteschenkeln, die zur Fixierung des Gehäuses in der Fußboden-Ausnehmung Widerhaken aufweisen. Durch Aufsetzen einer Abdeckung werden die Halteschenkel mit den Widerhaken nach außen gespreizt, so dass die Widerhaken das Gehäuse in der Fußboden-Ausnehmung sichern. Nachteilig bei diesem Einbau-Gehäuse ist, dass dessen Aufbau und Montage sowie Demontage aufwendig ist.

Der Erfindung liegt die Aufgabe zugrunde, ein Einbau-Gehäuse zur Aufnahme und sicheren Befestigung einer elektrischen Komponente zu schaffen, dessen Aufbau und Montage sowie Demontage einfach ist.

Diese Aufgabe wird durch ein Einbau-Gehäuse mit den Merkmalen des Anspruchs 1 gelöst. Die Gehäuseteile, die den Aufnahmeraum für die elektrische Komponente begrenzen, bilden eine Drehverbindung aus und sind durch Schließen der Drehverbindung miteinander verbindbar und durch Lösen der Drehverbindung voneinander lösbar. Dadurch, dass an dem ersten Gehäuseteil mindestens ein Spreizelement angeordnet ist, das durch ein Schließen der Drehverbindung von dem zweiten Gehäuseteil aufspreizbar ist, wird das zweite Gehäuseteil durch Schließen der Drehverbindung in einfacher Weise mit dem ersten Gehäuseteil verbunden und gleichzeitig das mindestens eine Spreizelement aufgespreizt bzw. radial ausgelenkt, wodurch das Einbau-Gehäuse in einfacher Weise in einer zugehörigen Ausnehmung verspreizt und befestigt wird. Durch das Schließen der Drehverbindung wird das Einbau-Gehäuse somit verschlossen und befestigt. Der Aufbau und die Montage des Einbau-Gehäuses sind somit einfach und die Befestigung sicher.

Zur Demontage des Einbau-Gehäuses wird die Drehverbindung geöffnet, wodurch gleichzeitig die Verspreizung bzw. Befestigung des Einbau-Gehäuses in der zugehörigen Ausnehmung gelöst wird. Das Einbau-Gehäuse ist somit auch einfach demontierbar.

Die Drehverbindung ist insbesondere aus der Gruppe Gewindeverbindung und Bajonettverbindung ausgewählt. Vorzugsweise bilden die Gehäuseteile ein Innengewinde und ein zugehöriges Außengewinde aus, so dass die Gehäuseteile durch Verschrauben miteinander verbindbar sind. Vorzugsweise ist das Innengewinde an dem ersten Gehäuseteil und das Außengewinde an dem zweiten Gehäuseteil ausgebildet.

Ein Einbau-Gehäuse nach Anspruch 2 gewährleistet einen einfachen Aufbau und eine einfache Montage. Dadurch, dass das mindestens eine Spreizelement an der ringförmigen Seitenwand des ersten Gehäuseteils angeordnet ist, ist dieses einfach radial zu der Mittellängsachse aufspreizbar bzw. auslenkbar, indem das zweite Gehäuseteil beim Schließen der Drehverbindung relativ zu dem ersten Gehäuseteil um die Mittellängsachse verdreht wird. Vorzugsweise weist das erste Gehäuseteil einen Gehäuseboden auf, an dem die ringförmige Seitenwand befestigt ist. Vorzugsweise sind der Gehäuseboden und die Seitenwand einteilig ausgebildet.

Ein Einbau-Gehäuse nach Anspruch 3 gewährleistet einen einfachen Aufbau. Durch die einteilige Anordnung des mindestens einen Spreizelements an dem ersten Gehäuseteil wird eine einfache Herstellung gewährleistet. Zudem wird auf einfache Weise eine federnde Anordnung ermöglicht. Durch eine federnde Anordnung wird auf einfache Weise eine Demontage des Einbau-Gehäuses gewährleistet, da das mindestens eine Spreizelement , beim Lösen der Drehverbindung selbsttätig wieder den ungespreizten Zustand einnimmt.

Ein Einbau-Gehäuse nach Anspruch 4 ermöglicht auf einfache Weise die Bereitstellung des mindestens einen Spreizelements. Dadurch, dass das mindestens eine Spreizelement eine in radialer Richtung zunehmende Wanddicke hat, erstreckt sich das mindestens eine Spreizelement im ungespreizten Zustand in den Aufnahmeraum. Durch das Schließen der Drehverbindung wird das mindestens eine Spreizelement von dem zweiten Gehäuseteil aus dem Aufnahmeraum verdrängt, wodurch das mindestens eine Spreizelement in radialer Richtung ausgelenkt wird. Im ausgelenkten bzw. gespreizten Zustand erstreckt sich das mindestens eine Spreizelement über den Außenumfang des ersten Gehäuseteils hinaus, so dass das Einbau-Gehäuse in der zugehörigen Ausnehmung verspreizt und befestigt wird.

Ein Einbau-Gehäuse nach Anspruch 5 gewährleistet auf einfache Weise die Montage und Demontage. Dadurch, dass sich der Innenradius rₛ des mindestens einen Spreizelements in Richtung seines freien Endes verkleinert, erstreckt sich das mindestens eine Spreizelement im ungespreizten Zustand in dem Aufnahmeraum. Durch das Schließen der Drehverbindung wird das mindestens eine Spreizelement von dem zweiten Gehäuseteil aus dem Aufnahmeraum verdrängt und in radialer Richtung ausgelenkt. Im ausgelenkten Zustand steht das mindestens eine Spreizelement über den Außenumfang des ersten Gehäuseteils hinaus, wodurch das Einbau-Gehäuse auf einfache Weise in der zugehörigen Ausnehmung verspreizt und befestigt wird.

Ein Einbau-Gehäuse nach Anspruch 6 gewährleistet eine einfache Montage und Demontage. Dadurch, dass der Außenradius Rₛ des mindestens einen Spreizelements im ungespreizten Zustand dem Außenradius R_{G} des ersten Gehäuseteils entspricht, ist das Einbau-Gehäuse auf einfache Weise in die Ausnehmung einführbar bzw. aus dieser zu entfernen. Wird das mindestens eine Spreizelement beim Schließen der Drehverbindung aufgespreizt, so steht das mindestens eine Spreizelement über den Außenumfang des ersten Gehäuseteils hinaus und verspreizt das Einbau-Gehäuse in der Ausnehmung. Dadurch, dass der Außenradius Rₛ dem Außenradius R_{G} entspricht, erfolgt eine großflächige Verspreizung in der Ausnehmung.

Ein Einbau-Gehäuse nach Anspruch 7 gewährleistet auf einfache Weise eine sichere Befestigung. Durch die Profilierung an der Außenwand des mindestens einen Spreizelements wird die Verbindung zu dem den Aufnahmeraum bildenden Gegenstand verbessert.

Ein Einbau-Gehäuse nach Anspruch 8 gewährleistet auf einfache Weise eine sichere Befestigung. Die in Umfangsrichtung verlaufenden Rippen verhindern auf wirkungsvolle Weise eine Bewegung des Einbau-Gehäuses in Richtung der Mittellängsachse.

Ein Einbau-Gehäuse nach Anspruch 9 gewährleistet auf einfache Weise eine sichere Befestigung. Durch die Mehrzahl der Spreizelemente wird der Außenumfang des ersten Gehäuseteils in unterschiedlichen radialen Richtungen vergrößert, wodurch eine gleichmäßige und sichere Befestigung in der Ausnehmung gewährleistet ist.

Ein Einbau-Gehäuse nach Anspruch 10 gewährleistet eine einfache Montage. Dadurch, dass die Gehäuseteile mindestens einen Anschlag und einen zugehörigen Gegenanschlag ausbilden, wird die Verdrehbewegung in einfacher Weise in einem aufgespreizten Zustand des mindestens einen Spreizelements gestoppt. Hierdurch wird ein übermäßiges Verdrehen der Gehäuseteile und ein damit verbundenes Überführen des mindestens einen Spreizelements von einer gewünschten gespreizten Stellung zu einer unerwünschten ungespreizten Stellung vermieden.

Ein Einbau-Gehäuse nach Anspruch 11 gewährleistet auf einfache Weise eine sichere Befestigung. Durch das mindestens eine Anlageelement wird ein sicheres und insbesondere großflächiges Aufspreizen des mindestens einen Spreizelements gewährleistet.

Ein Einbau-Gehäuse nach Anspruch 12 gewährleistet eine einfache Montage und Demontage. Durch das Werkzeugangriffselement wird ein einfaches Schließen und Öffnen der Drehverbindung und ein damit verbundenes Aufspreizen und Lösen des mindestens einen Spreizelements gewährleistet. Das Werkzeugangriffselement ist insbesondere als Ausnehmung in einem der Gehäuseteile ausgebildet. Vorzugsweise ist das Werkzeugsangriffselement an dem zweiten Gehäuseteil angeordnet.

Ein Einbau-Gehäuse nach Anspruch 13 gewährleistet eine einfache Montage und Demontage. Leitungsverbindungen für die elektrische bzw. elektronische Komponente, die in dem Aufnahmeraum angeordnet werden soll bzw. ist, können durch die mindestens eine Durchgangsöffnung auf einfache Weise in den Aufnahmeraum geführt werden. Die Montage bzw. Demontage des Einbau-Gehäuses wird hierdurch nicht beeinträchtigt. Die mindestens eine Durchgangsöffnung ist vorzugsweise in dem Gehäuseteil ausgebildet, in dem auch das Werkzeugangriffselement angeordnet ist. Hierdurch kann das aufgrund des Werkzeugangriffselements freiliegende Gehäuseteil gleichzeitig zur Zu- bzw. Anführung der Leitungsverbindungen durch die mindestens eine Durchgangsöffnung genutzt werden. Vorzugsweise sind die mindestens eine Durchgangsöffnung und das Werkzeugangriffselement in dem zweiten Gehäuseteil ausgebildet.

Der Erfindung liegt ferner die Aufgabe zugrunde, einen Gegenstand, insbesondere ein Möbel zu schaffen, das auf einfache Weise eine sichere Befestigung einer elektrischen bzw. elektronischen Komponente ermöglicht.

Diese Aufgabe wird durch einen Gegenstand mit den Merkmalen des Anspruchs 14 gelöst. Der Grundkörper weist eine Ausnehmung auf, die in ihrer Form und Größe dem Einbau-Gehäuse entspricht. Das Einbau-Gehäuse kann in einfacher Weise mittels des mindestens einen Spreizelements in der Ausnehmung verspreizt bzw. verklemmt werden. Eine in dem Aufnahmeraum angeordnete elektrische bzw. elektronische Komponente kann somit einfach und schnell an dem Grundkörper montiert und wieder demontiert werden. Vorzugsweise dient die elektrische bzw. elektronische. Komponente zum drahtlosen Laden von Mobilfunkgeräten. Die Ausnehmung ist als Durchgangsbohrung oder als Sacklochbohrung ausgebildet.

Der Erfindung liegt ferner die Aufgabe zugrunde, ein Verfahren zu schaffen, das eine einfache und sichere Befestigung eines Einbau-Gehäuses an einem Gegenstand ermöglicht.

Diese Aufgabe wird durch ein Verfahren mit den Merkmalen des Anspruchs 15 gelöst. Die Vorteile des erfindungsgemäßen Verfahrens entsprechen den bereits beschriebenen Vorteilen des erfindungsgemäßen Einbau-Gehäuses. Das erfindungsgemäße Verfahren kann insbesondere auch mit den Merkmalen der Ansprüche 1 bis 14 weitergebildet werden. Das erste Gehäuseteil wird zunächst in der Ausnehmung des Gegenstands angeordnet. Der Aufnahmeraum, in dem sich die elektrische bzw. elektronische Komponente befindet, wird anschließend mittels des zweiten Gehäuseteils verschlossen. Hierzu werden die Gehäuseteile durch Schließen der Drehverbindung miteinander verbunden, wodurch das zweite Gehäuseteil das mindestens eine Spreizelement aufspreizt und das erste Gehäuseteil mit dem damit verbundenen zweiten Gehäuseteil in der Ausnehmung des Gegenstands befestigt. Durch Schließen der Drehverbindung wird das Einbau-Gehäuse somit gleichzeitig verschlossen und in der Ausnehmung verklemmt. Zur Demontage wird die Drehverbindung geöffnet, wodurch die Verklemmung mittels des mindestens einen Spreizelements gelöst wird.

Weitere Merkmale, Vorteile und Einzelheiten der Erfindung ergeben sich aus der nachfolgenden Beschreibung mehrerer Ausführungsbeispiele. Es zeigen:
- Fig. 1: eine perspektivische Ansicht eines Einbau-Gehäuses zur Aufnahme und Befestigung einer elektrischen Komponente gemäß einem ersten Ausführungsbeispiel,
- Fig. 2: eine perspektivische Ansicht eines ersten Gehäuseteils des EinbauGehäuses in Fig. 1,
- Fig. 3: eine perspektivische Ansicht eines zweiten Gehäuseteils des Einbau-Gehäuses in Fig. 1,
- Fig. 4: eine teilweise geschnittene Draufsicht auf das Einbau-Gehäuse gemäß Fig. 1 in einem zum Einbau vorbereiteten Zustand,
- Fig. 5: einen Axialschnitt durch das Einbau-Gehäuse entlang der Schnittlinie V-V in Fig. 4,
- Fig. 6: eine teilweise geschnittene Draufsicht auf das Einbau-Gehäuse gemäß Fig. 1 in einem befestigten Zustand,
- Fig. 7: einen Axialschnitt durch das Einbau-Gehäuse entlang der Schnittlinie VII-VII in Fig. 6, und
- Fig. 8: eine perspektivische Ansicht eines Einbau-Gehäuses gemäß einem zweiten Ausführungsbeispiel.

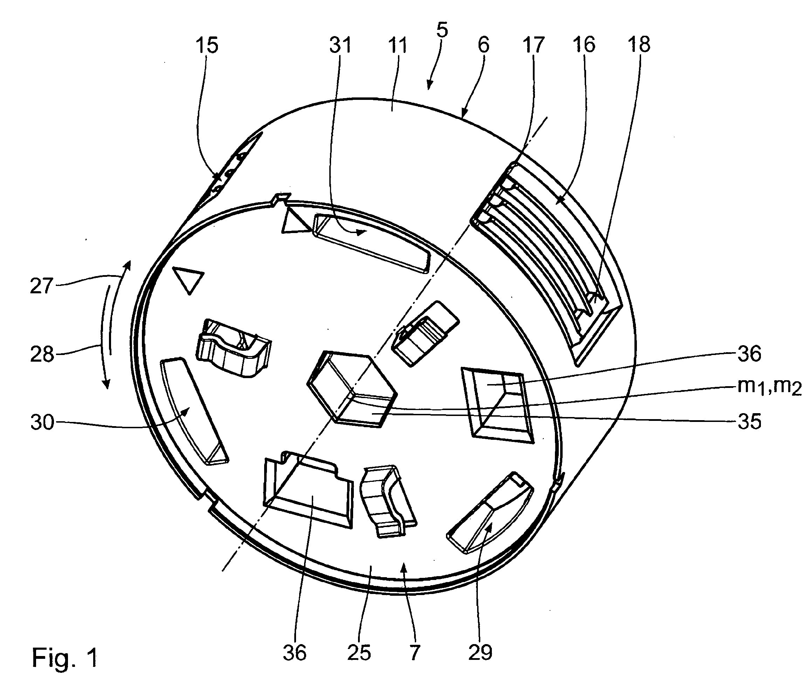

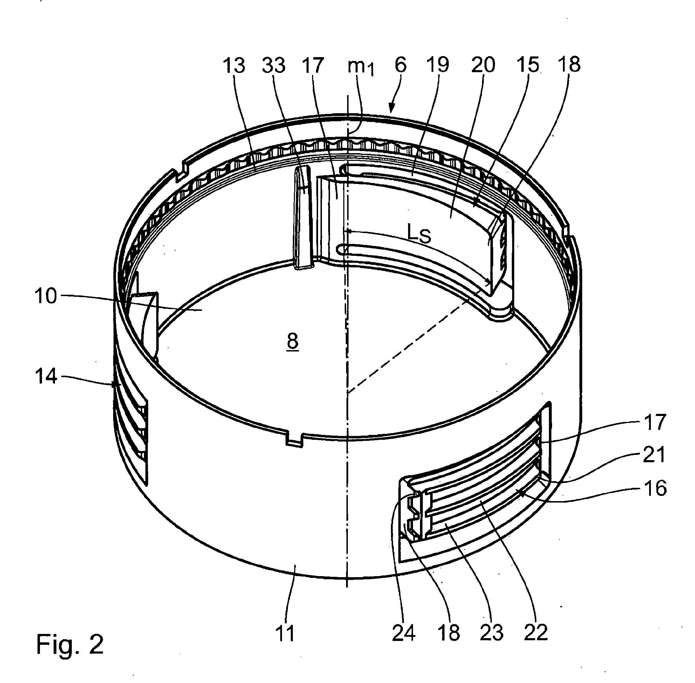

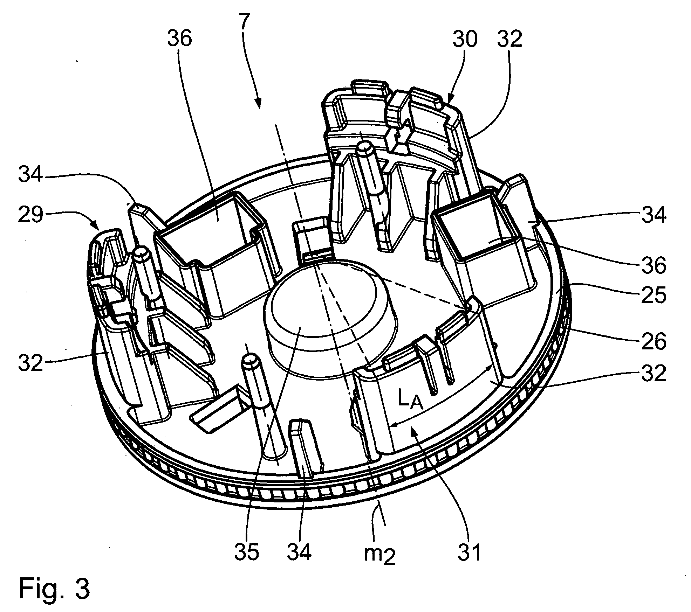

Nachfolgend ist anhand der Fig. 1 bis 7 ein erstes Ausführungsbeispiel der Erfindung beschrieben. Ein als Möbel ausgebildeter Gegenstand 1 weist einen Grundkörper 2 auf, in dem eine Ausnehmung 3 ausgebildet ist. Die Ausnehmung 3 ist im Querschnitt kreisförmig und weist eine Mittellängsachse M auf, von der eine die Ausnehmung 3 begrenzende Grundkörper-Seitenwand 4 einen Abstand R hat. Die Ausnehmung 3 ist als Sackloch ausgebildet.

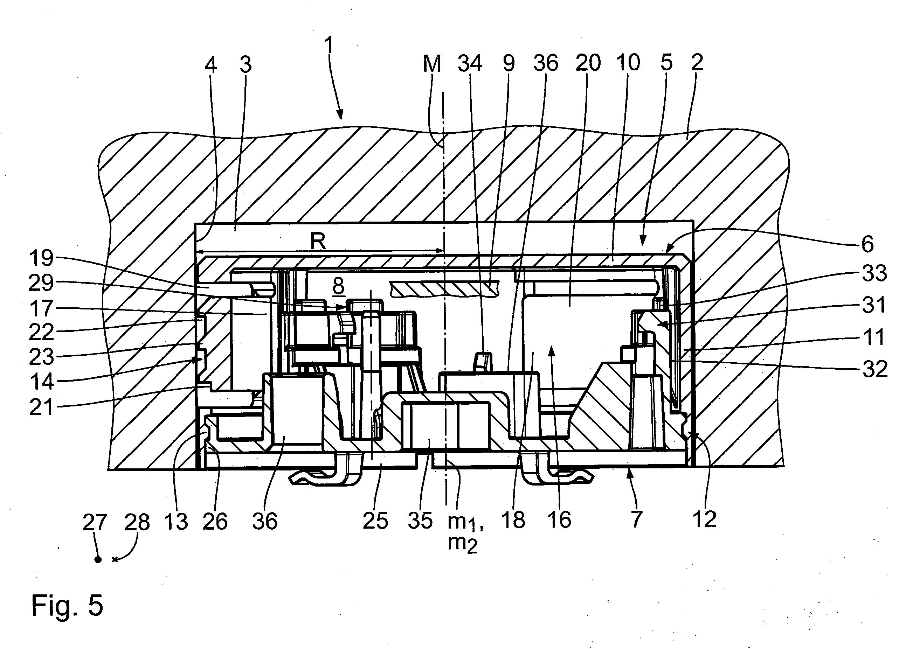

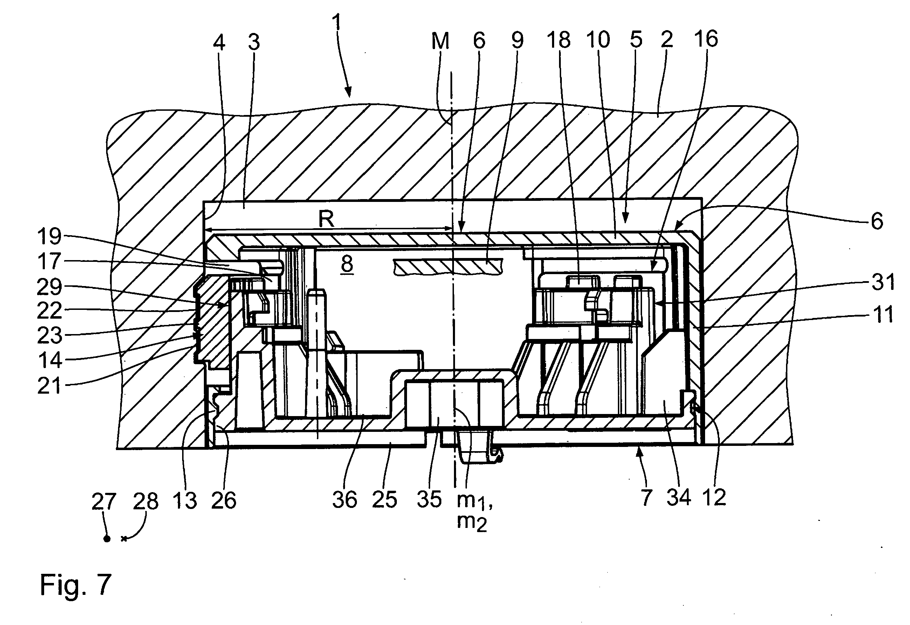

Die Ausnehmung 3 dient zum Einbau eines Einbau-Gehäuses 5. Das Einbau-Gehäuse 5 weist ein erstes Gehäuseteil 6 und ein zweites Gehäuseteil 7 auf, die einen Aufnahmeraum 8 begrenzen. Der Aufnahmeraum 8 dient zur Aufnahme einer elektrischen bzw. elektronischen Komponente 9, die lediglich in den Fig. 5 und 7 angedeutet ist.

Das erste Gehäuseteil 6 weist einen Boden 10 auf, an dem eine ringförmige Seitenwand 11 angeordnet ist. Das erste Gehäuseteil 6 weist eine Mittellängsachse m₁ auf, von der die Seitenwand 11 an ihrer Innenseite einen Abstand r_{G} und an ihrer Außenseite einen Abstand R_{G} aufweist. Die Gehäuseteile 6, 7 sind mittels einer Drehverbindung 12 miteinander verbindbar. Hierzu weist das erste Gehäuseteil 6 an einem dem Boden 10 abgewandten Ende der Seitenwand 11 ein Innengewinde 13 auf.

Zur Befestigung des Einbau-Gehäuses 5 in der zugehörigen Ausnehmung 3 weist das erste Gehäuseteil 6 drei Spreizelemente 14 bis 16 auf. Die Spreizelemente 14 bis 16 sind in der Seitenwand 11 zwischen dem Boden 10 und dem Innengewinde 13 ausgebildet. Die Spreizelemente 14 bis 16 sind in Umfangsrichtung gleichmäßig um die Mittellängsachse m₁ verteilt, haben also einen Winkelabstand von 120 ° bezogen auf die Mittellängsachse m₁. Die Spreizelemente 14 bis 16 weisen jeweils ein erstes Ende 17 auf, das einteilig mit der Seitenwand 11 ausgebildet ist. Ausgehend von dem jeweiligen ersten Ende 17 erstrecken sich die Spreizelemente 14 bis 16 in Umfangsrichtung um die Mittellängsachse m₁ und weisen jeweils ein freies zweites Ende 18 auf. Die Spreizelemente 14 bis 16 werden somit durch eine jeweilige U-förmige Durchbrechung 19 in der Seitenwand 11 gebildet. Die Spreizelemente 14 bis 16 sind einteilig und federnde an dem ersten Gehäuseteil 6 bzw. dessen Seitenwand 11 angeordnet. Die Spreizelemente 14 bis 16 sind aufgrund ihrer Ausbildung und Anordnung radial zu der Mittellängsachse m₁ aufspreizbar bzw. auslenkbar.

Die Spreizelemente 14 bis 16 haben jeweils eine dem Aufnahmeraum 8 zugewandte Innenwand 20 und eine dem Aufnahmeraum 8 abgewandte Außenwand 21. Die Innenwände 20 sind glatt ausgebildet. Die Außenwände 21 weisen einen Abstand bzw. Außenradius R_{S} von der Mittellängsachse m₁ auf, der im nicht ausgelenkten bzw. nicht gespreizten Zustand der Spreizelemente 14 bis 16 dem Abstand bzw. dem Außenradius R_{G} entspricht. Weiterhin weisen die Innenwände 20 von der Mittellängsachse-m₁ jeweils einen Abstand bzw. Innenradius r_{S} auf, der nicht konstant ist, sondern sich ausgehend von dem ersten Ende 17 des jeweiligen Spreizelements 14 bis 16 zu dem zugehörigen zweiten Ende 18 verkleinert. Die Innenwände 20 der Spreizelemente 14 bis 16 verjüngen sich somit in Richtung ihres freien Endes 18. An den ersten Enden 17 ist der Innenradius r_{S} geringfügig kleiner als der Abstand bzw. Innenradius r_{G}. Es gilt: r_{S} ≈ 0,97 r_{G}. Demgegenüber gilt für r_{S} an den freien Enden 18 des jeweiligen Spreizelements 14 bis 16: r_{S} ≤ 0,96 r_{G}, insbesondere r_{S} ≤ 0,93 r_{G}, und insbesondere r_{S} ≤ 0,90 r_{G}. Die Spreizelemente 14 bis 16 weisen somit eine Wanddicke w auf, für die allgemein gilt: w = R_{S} - rₛ. Die Wanddicke w ist in Richtung des jeweiligen freien Endes 18 der Spreizelemente 14 bis 16 in radialer Richtung zunehmend.

Die Spreizelemente 14 bis 16 weisen an ihren Außenwänden 21 in Umfangsrichtung verlaufende Nuten 22 auf, so dass die Außenwände 21 in Umfangsrichtung verlaufende Rippen 23 ausbilden. Die Außenwände 21 weisen somit eine Profilierung auf. An ihren freien Enden 18 weisen die Spreizelemente 14 bis 16 außerdem mehrere Widerhaken 24 auf, die für eine sichere Befestigung ebenfalls an den Außenwänden 21 angeordnet sind. Die Widerhaken 24 sind Teil der Profilierung.

Die Gehäuseteile 6, 7 sind derart ausgebildet, dass die Spreizelemente 14 bis 16 durch das Schließen der Drehverbindung 12 von dem zweiten Gehäuseteil 7 in radialer Richtung aufgespreizt bzw. ausgelenkt werden. Das zweite Gehäuseteil 7 weist einen im Wesentlichen scheibenförmigen Deckel 25 mit einer Mittellängsachse m₂ auf. Zum Schließen der Drehverbindung 12 ist an dem Deckel 25 umfangsseitig ein Außengewinde 26 ausgebildet, das durch eine Drehbewegung um die Mittellängsachse m₂ in das zugehörige Innengewinde 13 einschraubbar ist. Die Drehverbindung 12 ist derart ausgebildet, dass das zweite Gehäuseteil 7 zum Schließen der Drehverbindung 12 relativ zu dem ersten Gehäuseteil 6 in einer Schließrichtung 27 zu verdrehen ist, die ausgehend von den ersten Enden 17 der Spreizelemente 14 bis 16 zu den freien Enden 18 verläuft. Umgekehrt verläuft eine Öffnungsrichtung 28 ausgehend von den freien Enden 18 der Spreizelemente 14 bis 16 zu den ersten Enden 17.

Zum Aufspreizen der Spreizelemente 14 bis 16 sind an der dem Aufnahmeraum 8 zugewandten Innenseite des Deckels 25 eine den Spreizelementen 14 bis 16 entsprechende Anzahl an Anlageelementen 29 bis 31 angeordnet. Die Anlageelemente 29 bis 31 sind in Umfangsrichtung gleichmäßig um die Mittellängsachse m₂ beabstandet, also im Winkelabstand von 120 ° zueinander angeordnet. Die Anlageelemente 29 bis 31 weisen jeweils eine Außenwand 32 auf, die von der Mittellängsachse m₂ einen Abstand bzw. Außenradius R_{A} hat, der dem Innenradius rₛ der Spreizelemente 14 bis 16 an ihren Enden 17 entspricht. Die Außenwände 32 sind somit gekrümmt ausgebildet, wobei der Krümmungsradius dem Innenradius rₛ an den freien Enden 17 entspricht, so dass die Anlageelemente 29 bis 31 gegen die zugehörigen Spreizelemente 14 bis 16 anliegen. Die Anlageelemente 29 bis 31 haben in Umfangsrichtung eine Länge L_{A} für die im Verhältnis zu einer Länge Lₛ der Spreizelemente 14 bis 16 gilt: L_{A} / L_{S} ≥ 0,5, insbesondere L_{A} / L_{S} ≥ 0,6, und insbesondere L_{A} / L_{S} ≥ 0,7. Hierdurch werden die Spreizelemente 14 bis 16 von den zugehörigen Anlageelementen 29 bis 31 großflächig aufgespreizt, wobei die Anlageelemente 29 bis 31 einen großflächigen Anpressdruck in radialer Richtung erzeugen.

Zum Stoppen der Verdrehbewegung der Gehäuseteile 6, 7 relativ zueinander in einem aufgespreizten Zustand weist das Gehäuseteil 6 Anschläge 33 und das Gehäuseteil 7 zugehörige Gegenanschläge 34 auf. Die Anschläge 33 sind als Stege ausgebildet, die im Aufnahmeraum 8 an der Seitenwand 11 angeordnet sind. Die Anschläge 33 verlaufen im Wesentlichen parallel zu der Mittellängsachse m₁. Weiterhin sind die Anschläge 33 benachbart zu den ersten Enden 17 der Spreizelemente 14 bis 16 an der Seitenwand 11 angeordnet. Die Anschläge 33 sind einteilig mit der Seitenwand 11 ausgebildet. Der Abstand Rₜ der Anschläge 33 von der Mittellängsachse m₁ entspricht im Wesentlichen dem Abstand rₛ an den Enden 17 der Spreizelemente 14 bis 16.

Die Gegenanschläge 34 sind an der Innenseite des Deckels 25 angeordnet. Die Gegenanschläge 34 sind als Stege ausgebildet, die im Wesentlichen in Richtung der Mittellängsachse m₂ verlaufen. Die Gegenanschläge 34 sind derart von der Mittellängsachse m₂ beabstandet, dass sich diese mit den Anschlägen 33 überlappen. Die Gegenanschläge 34 haben von der Mittellängsachse m₂ einen maximalen Abstand R_{T}, der dem Innenradius r_{G} des ersten Gehäuseteils 7 entspricht.

Zum Schließen und Öffnen der Drehverbindung 12 ist an einer dem Aufnahmeraum 8 abgewandten Außenseite des Gehäuseteils 7 ein Werkzeugangriffselement 35 angeordnet. Das Werkzeugangriffselement 35 ist konzentrisch zu der Mittellängsachse m₂ angeordnet. Das Werkzeugangriffselement 35 ist als Ausnehmung ausgebildet, die beispielsweise eine sechseckige Form hat. Darüber hinaus sind in dem zweiten Gehäuseteil 7 mehrere Durchgangsöffnungen 36 ausgebildet, die in den Aufnaluneraum 8 münden. Die Durchgangsöffnungen 36 dienen zum Zuführen von nicht näher dargestellten Leitungsverbindungen für die elektrische bzw. elektronische Komponente 9 in den Aufnahmeraum 8.

Die Funktionsweise des Einbau-Gehäuses 5 ist wie folgt:
Die elektrische bzw. elektronische Komponente 9 wird zunächst in dem Aufnahmeraum 8 angeordnet und die Leitungsverbindungen durch die Durchgangsöffnungen 36 geführt. Anschließend wird das zweite Gehäuseteil 7 an dem ersten Gehäuseteil 6 angeordnet, wobei die Drehverbindung 12 zunächst noch geöffnet bleibt. Die Mittellängsachsen m₁ und m₂ sind deckungsgleich. Um das zweite Gehäuseteil 7 in einer gewünschten Position an dem ersten Gehäuseteil 6 anzuordnen, ist eine erste Markierung 37 an dem zweiten Gehäuseteil 7 angeordnet.

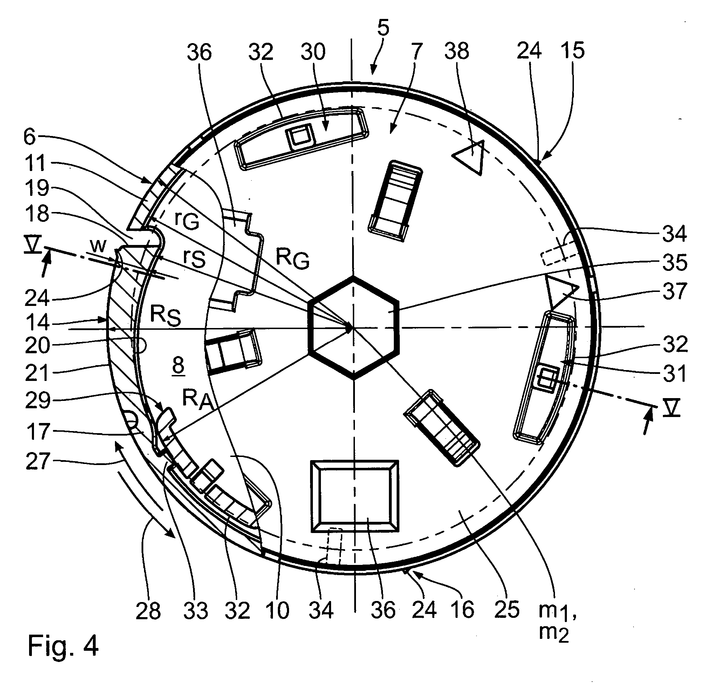

Das Einbau-Gehäuse 5 mit der darin aufgenommenen elektrischen bzw. elektronischen Komponente 9 wird nun in der Ausnehmung 3 angeordnet. Der Radius R der Ausnehmung 3 ist hierzu geringfügig größer als der Außenradius des Gehäuses R_{G}. Das Einbau-Gehäuse 5 ist im geöffneten Zustand, in dem die Spreizelemente 14 bis 16 nicht ausgelenkt sind, in den Fig. 4 und 5 veranschaulicht.

Zum Schließen der Drehverbindung 12 wird ein Werkzeug an dem Werkzeugangriffselement 35 angesetzt und das zweite Gehäuseteil 7 in der Schließrichtung 27 um die Mittellängsachse m₁ bzw. m₂ gedreht. Damit sich das erste Gehäuseteil 6 nicht in der Ausnehmung 3 mitdreht, ragen die Widerhaken 24 in der ungespreizten Stellung der Spreizelemente 14 bis 16 geringfügig über die Seitenwand 11 hinaus, so dass sich diese in der Grundkörper-Seitenwand 4 verhaken können. Das Einführen des Einbau-Gehäuses 5 in die Ausnehmung 3 wird durch die Widerhaken 24 nicht beeinträchtigt, da die Spreizelemente 14 bis 16 federnd sind und beim Einführen um den geringen Überstand der Widerhaken 24 in Richtung des Aufnahmeraumes 8 verlagert werden können.

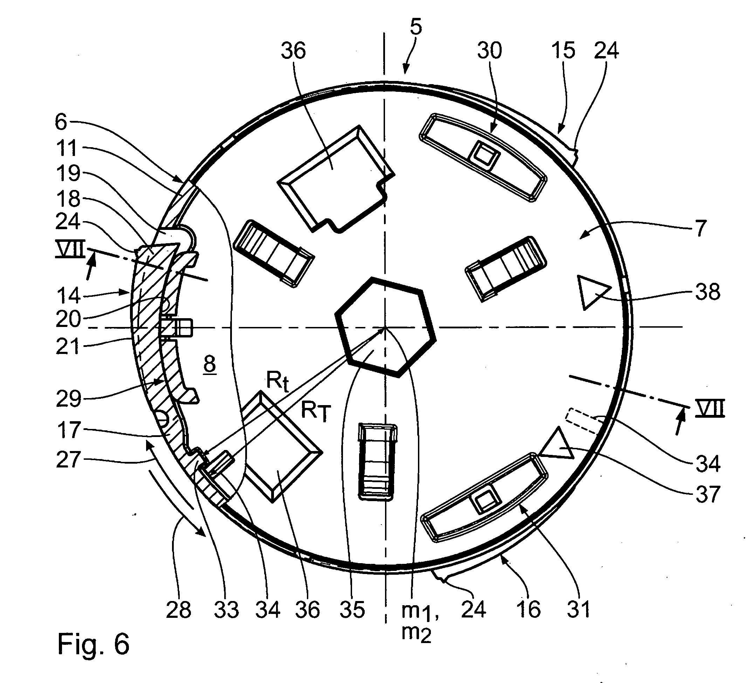

Durch die Verdrehbewegung der Gehäuseteile 6, 7 wird die Drehverbindung 12 geschlossen, so dass die Gehäuseteile 6, 7 miteinander verbunden sind. Da an dem zweiten Gehäuseteil 7 die Anlageelemente 29 bis 31 angeordnet sind, werden diese bei der Verdrehbewegung in Richtung der freien Enden 18 der Spreizelemente 14 bis 16 verlagert. Beim Verlagern der Anlageelemente 29 bis 31 liegen diese mit ihren Außenwänden 32 gegen die zugehörigen Innenwände 20 der Spreizelemente 14 bis 16 an. Da sich die Innenwände 20 in der Schließrichtung 27 verjüngen und somit sich in den Aufnahmeraum 8 erstrecken, werden die Spreizelemente 14 bis 16 bei der Verdrehbewegung in radialer Richtung ausgelenkt. Das Einbau-Gehäuse 5 ist in der ausgelenkten bzw. gespreizten Stellung der Spreizelemente 14 bis 16 in den Fig. 6 und 7 veranschaulicht. Die Spreizelemente 14 bis 16 werden derart aufgespreizt, dass deren Außenradius größer als der Außenradius R der Ausnehmung 3 ist. Die Außenwände 21 der Spreizelemente 14 bis 16 werden mit ihrer Profilierung, also mit den Nuten 22 und den zugehörigen Rippen 23 sowie den Widerhaken 24, in das Material des Grundkörpers 2 gepresst. Durch die in Umfangsrichtung verlaufenden Rippen 23 ist das Einbau-Gehäuse 5 insbesondere in Richtung der Mittellängsachse m₁ bzw. m₂ gesichert.

Die Verdrehbewegung der Gehäuseteile 6, 7 wird gestoppt, wenn die Anschläge 33 und die zugehörigen Gegenanschläge 34 aufeinander treffen. Die Anlageelemente 29 bis 31 liegen dann mit ihren Außenwänden 32 vollflächig gegen die Innenwände 20 der zugehörigen Spreizelemente 14 bis 16 an. Zum Anzeigen der gespreizten Stellung der Spreizelemente 14 bis 16 ist an dem zweiten Gehäuseteil 7 eine zweite Markierung 38 angeordnet.

Durch das Schließen der Drehverbindung 12 werden somit einerseits die Gehäuseteile 6, 7 miteinander verbunden und andererseits gleichzeitig die Spreizelemente 14 bis 16 ausgelenkt und das Einbau-Gehäuse 5 in einfacher Weise in der Ausnehmung 3 des Gegenstands 1 befestigt. Das Einbau-Gehäuse 5 gewährleistet somit eine einfache Montage und eine sichere Befestigung.

Zur Demontage des Einbau-Gehäuses 5 wird wiederum ein Werkzeug an das Werkzeugangriffselement 35 angesetzt und das zweite Gehäuseteil 7 in der Öffnungsrichtung 28 relativ zu dem ersten Gehäuseteil 6 verdreht. Aufgrund der ausgelenkten Spreizelemente 14 bis 16 ist das erste Gehäuseteil 6 bei der Verdrehbewegung fixiert. Durch die Verdrehbewegung in Öffnungsrichtung 28 werden die Anlageelemente 29 bis 31 von den Spreizelementen 14 bis 16 entfernt, wodurch die Spreizelemente 14 bis 16 aufgrund ihrer federnden Ausbildung wieder in ihren ursprünglichen ungespreizten Zustand zurückkehren. Die Befestigung des Einbau-Gehäuses 5 in der Ausnehmung 3 ist somit gelöst. Gleichzeitig ist die Verbindung der Gehäuseteile 6, 7 gelöst. Die Demontage des Einbau-Gehäuses 5 ist somit gleichermaßen einfach. Die Gehäuseteile 6, 7 können jeweils einteilig aus Kunststoff hergestellt werden. Der Aufbau und die Herstellung der Gehäuseteile 6, 7 ist vergleichsweise einfach.

Das Einbau-Gehäuse 5 dient beispielsweise zur Aufnahme und Befestigung einer elektronischen Komponente 9 zum drahtlosen Laden von Mobilfunkgeräten. Das Einbau-Gehäuse 5 wird hierzu beispielsweise an einem Möbel, insbesondere einem Tisch befestigt.

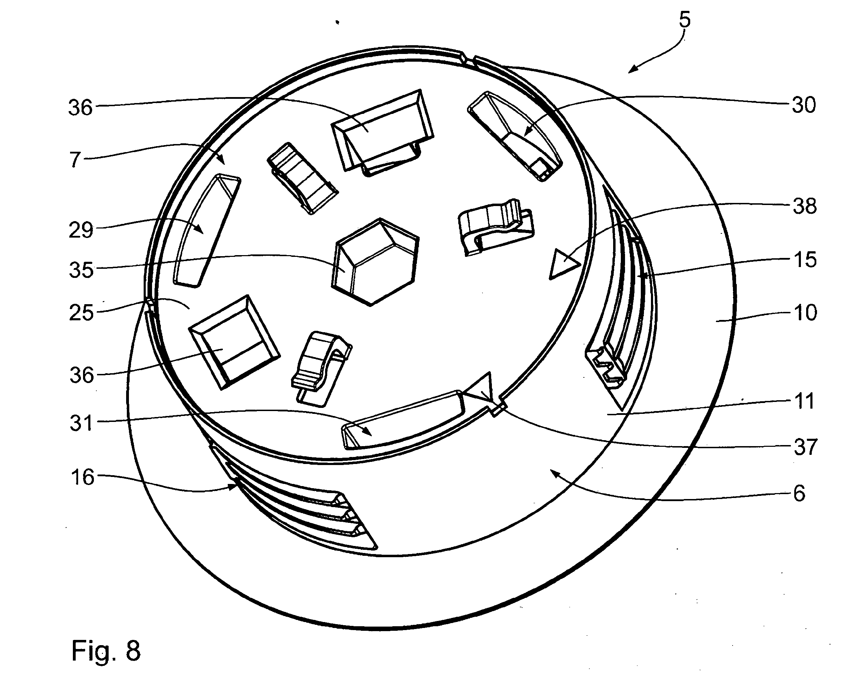

Nachfolgend ist anhand von Fig. 8 ein zweites Ausführungsbeispiel der Erfindung beschrieben. Im Unterschied zu dem ersten Ausführungsbeispiel steht der Boden 10 des ersten Gehäuseteils 6 in radialer Richtung über die Seitenwand 11 über und bildet somit einen Rand. Diese Ausgestaltung ist vorteilhaft, wenn die Ausnehmung 3 als Durchgangsbohrung ausgebildet ist. Der von dem Boden 10 gebildete Rand deckt dann die Ausnehmung 3 vollständig ab. Hinsichtlich des weiteren Aufbaus und der weiteren Funktionsweise des Einbau-Gehäuses 5 wird auf das erste Ausführungsbeispiel verwiesen.

## Patentansprüche

1. Einbau-Gehäuse zur Aufnahme und Befestigung einer elektrischen Komponente mit
- einem ersten Gehäuseteil (6) und einem mit dem ersten Gehäuseteil (6) verbindbaren zweiten Gehäuseteil (7), wobei an dem ersten Gehäuseteil (6) mindestens ein Spreizelement (14 bis 16) zur Befestigung des Einbau-Gehäuses in einer Ausnehmung (3) eines Gegenstands (1) angeordnet ist, und
- einem von den Gehäuseteilen (6, 7) begrenzten Aufnaluneraum (8) zur Aufnahme einer elektrischen Komponente (9),
**dadurch gekennzeichnet,**
**dass** die Gehäuseteile (6, 7) eine Drehverbindung (12) ausbilden, und **dass** das mindestens eine Spreizelement (14 bis 16) durch ein Schließen der Drehverbindung (12) von dem zweiten Gehäuseteil (7) aufspreizbar ist.

2. Einbau-Gehäuse nach Anspruch 1, **dadurch gekennzeichnet,**
**dass** das erste Gehäuseteil (6) eine ringförmige Seitenwand (11) mit einer Mittellängsachse (m₁) aufweist und
**dass** das mindestens eine Spreizelement (14 bis 16) an der Seitenwand (11) angeordnet und radial zu der Mittellängsachse (m₁) aufspreizbar ist.

3. Einbau-Gehäuse nach Anspruch 1 oder 2, **dadurch gekennzeichnet, dass** das mindestens eine Spreizelement (14 bis 16) einteilig.und/oder federnd an dem ersten Gehäuseteil (6) angeordnet ist.

4. Einbau-Gehäuse nach Anspruch 2 oder 3, **dadurch gekennzeichnet, dass** das mindestens eine Spreizelement (14 bis 16) ein an dem ersten Gehäuseteil (6) angeordnetes erstes Ende (17) und ein freies zweites Ende (18) aufweist, und
**dass** das mindestens eine Spreizelement (14 bis 16) in Richtung des zweiten Endes (18) eine in radialer Richtung zunehmende Wanddicke (w) hat.

5. Einbau-Gehäuse nach einem der Ansprüche 2 bis 4, **dadurch gekennzeichnet,**
**dass** das mindestens eine Spreizelement (14 bis 16) eine dem Aufnahmeraum (8) zugewandte Innenwand (20) mit einen Innenradius rₛ hat, **dass** sich der Innenradius rₛ in Richtung eines freien Ende (18) des mindestens einen Spreizelements (14 bis 16) verkleinert.

6. Einbau-Gehäuse nach einem der Ansprüche 2 bis 5, **dadurch gekennzeichnet,**
**dass** das mindestens eine Spreizelement (14 bis 16) eine dem Aufnahmeraum (8) abgewandte Außenwand (21) mit einen Außenradius Rₛ hat,
**dass** der Außenradius R_{S} einem Außenradius R_{G} der Seitenwand (11) entspricht.

7. Einbau-Gehäuse nach einem der Ansprüche 1 bis 6, **dadurch gekennzeichnet,**
**dass** zur Befestigung des ersten Gehäuseteils (6) in einer Ausnehmung (3) eines Gegenstands (1) das mindestens eine Spreizelement (14 bis 16) an einer dem Aufnahmeraum (8) abgewandte Außenwand (21) eine Profilierung (22, 23, 24) aufweist.

8. Einbau-Gehäuse nach Anspruch 7, **dadurch gekennzeichnet,**
**dass** die Profilierung (22, 23, 24) um die Mittellängsachse (m₁) verlaufende Rippen (23) umfasst.

9. Einbau-Gehäuse nach einem der Ansprüche 1 bis 8, **dadurch gekennzeichnet,**
**dass** mindestens zwei Spreizelemente (14 bis 16), und insbesondere mindestens drei Spreizelemente (14 bis 16) an dem ersten Gehäuseteil (6) angeordnet sind, wobei die Spreizelemente (14 bis 16) insbesondere gleichmäßig beabstandet um die Mittellängsachse (m₁) angeordnet sind.

10. Einbau-Gehäuse nach einem der Ansprüche 1 bis 9, **dadurch gekennzeichnet,**
**dass** die Gehäuseteile (6, 7) mindestens einen Anschlag (33) und einen zugehörigen Gegenanschlag (34) zum Stoppen einer Verdrehbewegung der Gehäuseteile (6, 7) relativ zueinander in einem aufgespreizten Zustand des mindestens einen Spreizelements (14 bis 16) aufweisen.

11. Einbau-Gehäuse nach einem der Ansprüche 1 bis 10, **dadurch gekennzeichnet,**
**dass** das zweite Gehäuseteil (7) mindestens ein Anlageelement (29 bis 31) zum Aufspreizen des mindestens einen Spreizelements (14 bis 16) aufweist, wobei für eine Länge L_{A} des mindestens einen Anlageelements (29 bis 31) zu einer Länge L_{S} des mindestens einen Spreizelements (14 bis 16) insbesondere gilt: L_{A}/L_{S} ≥ 0,5, insbesondere L_{A}/L_{S} ≥ 0,6, und insbesondere L_{A}/L_{S} ≥ 0,7.

12. Einbau-Gehäuse nach einem der Ansprüche 1 bis 11, **dadurch gekennzeichnet,**
**dass** mindestens eines der Gehäuseteile (6, 7) ein Werkzeugangriffselement (35) aufweist, das insbesondere konzentrisch zu der Mittellängsachse (m₁, m₂) angeordnet ist.

13. Einbau-Gehäuse nach einem der Ansprüche 1 bis 12, **dadurch gekennzeichnet,**
**dass** mindestens eines der Gehäuseteile (6, 7) mindestens eine Durchgangsöffnung (36) in den Aufnahmeraum (8) aufweist, wobei die mindestens eine Durchgangsöffnung (36) insbesondere in dem Gehäuseteil (6, 7) mit dem Werkzeugangriffselement (35) ausgebildet ist.

14. Gegenstand, insbesondere Möbel, umfassend
- einen Grundkörper (2),
- eine in dem Grundkörper (2) ausgebildete Ausnehmung (3),
wobei in der Ausnehmung (3) ein Einbau-Gehäuse (5) nach mindestens einem der Ansprüche 1 bis 13 befestigt ist.

15. Verfahren zur Befestigung eines Einbau-Gehäuses an einem Gegenstand, mit folgenden Schritten:
- Bereitstellen eines Einbau-Gehäuses (5) nach mindestens einem der Ansprüche 1 bis 13,
- Anordnen des ersten Gehäuseteils (6) in einer Ausnehmung (3) eines Gegenstands (1), insbesondere eines Möbels, und
- Verbinden des zweiten Gehäuseteils (7) mit dem ersten Gehäuseteil (6) durch Schließen der Drehverbindung (12), wobei das zweite Gehäuseteil (7) das mindestens eine Spreizelement (14 bis 16) aufspreizt und das Einbau-Gehäuse (5) in der Ausnehmung (3) befestigt.

## Claims

1. Insert casing for receiving and fastening an electrical component comprising
- a first casing part (6) and a second casing part (7) connectable to the first casing part (6), wherein at least one spreading member (14 to 16) is arranged at the first casing part (6) for fastening the insert casing in a recess (3) of an object, and
- a receiving space (8) defined by the casing parts (6, 7) for receiving an electrical component (9),
**characterized in**
**that** the casing parts (6, 7) form a rotary joint (12), and
**that** the at least one spreading member (14 to 16) is spreadable by the second casing part (7) when the rotary joint (12) is closed.

2. Insert casing according to claim 1, **characterized in**
**that** the first casing part (6) has an annular side wall (11) with a central longitudinal axis (m₁), and
**that** the at least one spreading member (14 to 16) is arranged at the side wall and is spreadable radially relative to the central longitudinal axis (m₁).

3. Insert casing according to claim 1 or 2, **characterized in**
**that** the at least one spreading member (14 to 16) is arranged in one piece and/or resiliently at the first casing part (6).

4. Insert casing according to claim 2 or 3, **characterized in**
**that** the at least one spreading member (14 to 16) has a first end (17) arranged at the first casing part (6) and a free second end (18), and **that** the at least one spreading member (14 to 16) has a wall thickness (w) that increases radially in the direction of the second end (18).

5. Insert casing according to one of claims 2 to 4, **characterized in that** the at least one spreading member (14 to 16) has an inner wall (20) with an inner radius r_{S} facing the receiving space (8),
**that** the inner radius r_{S} tapers in the direction of a free end (18) of the at least one spreading member (14 to 16).

6. Insert casing according to one of claims 2 to 5, **characterized in that** the at least one spreading member (14 to 16) has an outer wall (21) with an outer radius R_{S} remote from the receiving space (8), **that** the outer radius R_{S} corresponds to an outer radius R_{G} of the side wall (11).

7. Insert casing according to one of claims 1 to 6, **characterized in that** the at least one spreading member (14 to 16) is provided with a profile (22, 23, 24) at an outer wall (21) remote from the receiving space (8) for fastening the first casing part (6) in a recess (3) of an object (1).

8. Insert casing according to claim 7, **characterized in that** the profile (22, 23, 24) comprises ribs (23) running around the central longitudinal axis (m₁).

9. Insert casing according to one of claims 1 to 8, **characterized in that** at least two spreading members (14 to 16), and in particular at least three spreading members (14 to 16) are arranged at the first casing part (6), wherein the spreading members (14 to 16) are in particular arranged around the central longitudinal axis (m₁) such as to be evenly spaced from each other.

10. Insert casing according to one of claims 1 to 9, **characterized in that** the casing parts (6, 7) have at least one stop (33) and an associated counter-stop (34) for stopping a rotary movement of the casing parts (6, 7) relative to each other when the at least one spreading member (14 to 16) is spread open.

11. Insert casing according to one of claims 1 to 10, **characterized in that** the second casing part (7) has at least one contact member (29 to 31) for spreading the at least one spreading member (14 to 16), a length L_{A} of the at least one contact member (29 to 31) relative to a length L_{S} of the at least one spreading member (14 to 16) in particular being such that L_{A}/L_{S} ≥ 0.5, in particular L_{A}/L_{S} ≥ 0.6, and in particular L_{A}/L_{S} ≥ 0.7.

12. Insert casing according to one of claims 1 to 11, **characterized in that** at least one of the casing parts (6, 7) is provided with a tool engagement member (35) which is in particular arranged concentrically to the central longitudinal axis (m₁, m₂).

13. Insert casing according to one of claims 1 to 12, **characterized in that** at least one of the casing parts (6, 7) has at least one through-opening (36) into the receiving space (8), wherein the at least one through-opening (36) is in particular formed in the casing part (6, 7) with the tool engagement member (35).

14. Object, in particular piece of furniture, comprising
- a base body (2),
- a recess (3) formed in the base body (2),
wherein an insert casing (5) according to at least one of claims 1 to 13 is fastened in the recess (3).

15. Method for fastening an insert casing to an object, the method comprising the following steps:
- providing an insert casing (5) according to at least one of claims 1 to 13,
- arranging the first casing part (6) in a recess (3) of an object (1), in particular a piece of furniture, and
- connecting the second casing part (7) with the first casing part (6) by closing the rotary joint (12), wherein the second casing part (7) spreads the at least one spreading member (14 to 16) and fastens the insert casing (5) in the recess (3).

## Revendications

1. Boîtier encastrable destiné à loger et à fixer un composant électrique, comprenant
- une première partie de boîtier (6) et une deuxième partie de boîtier (7) pouvant être assemblée à la première partie de boîtier (6), au moins un élément expansible (14 à 16), destiné à fixer le boîtier encastrable dans un évidement (3) d'un objet (1), étant agencé sur la première partie de boîtier (6), et
- un espace de logement (8) délimité par les parties de boîtier (6, 7) et destiné à loger un composant électrique (9),
**caractérisé**
**en ce que** les parties de boîtier (6, 7) forment une liaison rotative (12), et
**en ce qu'**au moins un élément expansible (14 à 16) peut être écarté par la deuxième partie de boîtier (7) à la suite d'une fermeture de la liaison rotative (12).

2. Boîtier encastrable selon la revendication 1, **caractérisé**
**en ce que** la première partie de boîtier (6) présente une paroi latérale annulaire (11) pourvue d'un axe longitudinal médian (m₁) et
**en ce que** l'élément ou les éléments expansibles (14 à 16) sont agencés sur la paroi latérale (11) et peuvent être écartés radialement par rapport à l'axe longitudinal médian (m₁).

3. Boîtier encastrable selon la revendication 1 ou 2, **caractérisé**
**en ce que** l'élément ou les éléments à expansion (14 à 16) sont agencés en une seule pièce et/ou de manière élastique sur la première partie de boîtier (6).

4. Boîtier encastrable selon la revendication 2 ou 3, **caractérisé**
**en ce que** l'élément ou les éléments expansibles (14 à 16) présentent une première extrémité (17) agencée sur la première partie de boîtier (6) et une deuxième extrémité libre (18), et
**en ce que** l'élément ou les éléments expansibles (14 à 16) présentent en direction de la deuxième extrémité (18) une épaisseur de paroi (w) augmentant dans la direction radiale.

5. Boîtier encastrable selon l'une quelconque des revendications 2 à 4, **caractérisé**
**en ce que** l'élément ou les éléments expansibles (14 à 16) présentent une paroi intérieure (20) qui est tournée vers l'espace de logement (8) et qui présente un rayon intérieur r_{S},
**en ce que** le rayon intérieur rₛ diminue en direction d'une extrémité libre (18) de l'élément ou des éléments expansibles (14 à 16).

6. Boîtier encastrable selon l'une quelconque des revendications 2 à 5, **caractérisé**
**en ce que** l'élément ou les éléments expansibles (14 à 16) présentent une paroi extérieure (21) qui est opposée à l'espace de logement (8) et qui est pourvue d'un rayon extérieur Rₛ,
**en ce que** le rayon extérieur R_{S} correspond à un rayon extérieur R_{G} de la paroi latérale (11).

7. Boîtier encastrable selon l'une quelconque des revendications 1 à 6, **caractérisé**
**en ce que** pour fixer la première partie de boîtier (6) dans un évidement (3) d'un objet (1), l'élément ou les éléments expansibles (14 à 16) présentent un profilage (22, 23, 24) sur une paroi extérieure (21) opposée à l'espace de logement (8).

8. Boîtier encastrable selon la revendication 7, **caractérisé**
**en ce que** le profilage (22, 23, 24) comprend des nervures (23) s' étendant autour de l'axe longitudinal médian (m₁) .

9. Boîtier encastrable selon l'une quelconque des revendications 1 à 8, **caractérisé**
**en ce qu'**au moins deux éléments expansibles (14 à 16), et en particulier au moins trois éléments expansibles (14 à 16) sont agencés sur la première partie de boîtier (6), les éléments expansibles (14 à 16) étant agencés autour de l'axe longitudinal médian (m₁) en particulier à intervalle régulier.

10. Boîtier encastrable selon l'une quelconque des revendications 1 à 9, **caractérisé**
**en ce que** les parties de boîtier (6, 7) comprennent au moins une butée (33) et une contre-butée (34) associée destinée à arrêter un mouvement de torsion des parties de boîtier (6, 7) l'une par rapport à l'autre une fois l'élément ou les éléments expansibles (14 à 16) écartés.

11. Boîtier encastrable selon l'une quelconque des revendications 1 à 10, **caractérisé**
**en ce que** la deuxième partie de boîtier (7) comprend au moins un élément d'appui (29 à 31) destiné à écarter l'élément ou les éléments expansibles (14 à 16), où en particulier L_{A} /L_{S} ≥ 0,5, en particulier L_{A}/L_{S} ≥ 0,6, et en particulier L_{A}/L_{S} ≥ 0,7, pour une longueur L_{A} de l'élément ou des éléments d'appui (29 à 31) par rapport à une longueur L_{S} de l'élément ou des éléments expansibles (14 à 16).

12. Boîtier encastrable selon l'une quelconque des revendications 1 à 11, **caractérisé**
**en ce qu'**au moins une des parties de boîtier (6, 7) comprend un élément de prise d'outil (35), qui est agencé en particulier de manière concentrique par rapport à l'axe longitudinal médian (m₁, m₂) .

13. Boîtier encastrable selon l'une quelconque des revendications 1 à 12, **caractérisé**
**en ce qu'**au moins une des parties de boîtier (6, 7) comprend au moins une ouverture de passage (36) dans l'espace de logement (8), l'ouverture ou les ouvertures de passage (36) étant ménagées en particulier dans la partie de boîtier (6, 7) pourvue de l'élément de prise d'outil (35).

14. Objet, en particulier meuble, comprenant
- un corps de base (2),
- un évidement (3) ménagé dans le corps de base (2),
un boîtier encastrable (5) selon au moins l'une des revendications 1 à 13 étant fixé dans l'évidement (3).

15. Procédé de fixation d'un boîtier encastrable sur un objet, comprenant les étapes suivantes :
- la fourniture d'un boîtier encastrable (5) selon au moins l'une des revendications 1 à 13,
- l'agencement de la première partie de boîtier (6) dans un évidement (3) d'un objet (1), en particulier d'un meuble, et
- l'assemblage de la deuxième partie de boîtier (7) à la première partie de boîtier (6) à la suite de la fermeture de la liaison rotative (12), la deuxième partie de boîtier (7) écartant l'élément ou les éléments expansibles (14 à 16) et fixant le boîtier encastrable (5) dans l'évidement (3).
